# EUROPÄISCHE PATENTANMELDUNG

(11) **EP 1 213 877 A1**
(43) Veröffentlichungstag der Anmeldung: **12.06.2002**
(21) Anmeldenummer: 00127083.4
(22) Anmeldetag: 11.12.2000
(51) Int. Cl.: H04L 12/28, H04L 12/56, H05K 9/00

(54) **Hochintegrierte elektrische Schaltung und Verfahren zum Datenaustausch in einem abgeschlossenen System**

(71) Anmelder: SIEMENS AKTIENGESELLSCHAFT, 80333 München (DE)
(72) Erfinder: Ball, Carsten, Dr., 76764 Rheinzabern (DE); Deinzer, Arnulf, Dr., 81476 München (DE)

(57) **Zusammenfassung**

Hochintegrierte elektrische Schaltung und Verfahren zum Datenaustausch in einem abgeschlossenen System.

Die Erfindung betrifft eine hochintegrierte, elektrische Schaltung in einem abgeschlossenen abgeschirmten System und ein Verfahren in einem abgeschlossenen abgeschirmten System deren Komponenten und Baugruppen mittels nichtleitungsgebundener Funkkommunikation und mittels Vielfachzugriffsverfahren untereinander gleichzeitig Daten austauschen.

## Beschreibung

Die Erfindung betrifft eine hochintegrierte elektrische Schaltung in einem abgeschlossenen, elektrischen System und ein Verfahren zum Austausch von Daten zwischen Komponenten dieser Schaltung in einem abgeschlossenen, elektrischen System.

Stand der Technik sind hochintegrierte elektrische Schaltungen, die aus einer Vielzahl von elektrischen Komponenten bestehen und zum Beispiel auf einem Träger aufgebracht sind.
Bei diesem Träger kann es sich um eine Leiterplatte mit einer Schicht oder einer Vielzahl von Schichten, sogenannten Multilayern, handeln. Die einzelnen Komponenten kommunizieren dabei leitungsgebunden untereinander mittels einer Vielzahl von Leitungen.

So werden beispielsweise hochintegrierte Komponenten in SMD-Technik beidseitig auf einem Multilayer aufgebracht. Dabei wird eine möglichst hohe Packungsdichte auf dem Multilayer bei einer möglichst geringen Größe des Multilayers angestrebt. Seine Größe und die Packungsdichte seiner Komponenten wird dabei durch die Summe der aufgebrachten Komponentenflächen und durch die Anzahl der von den Komponenten benötigten Leiterbahnen bestimmt. Aufgrund der benötigten Flächen der Leiterbahnen ist die Packungsdichte der Komponenten stark begrenzt.

Weiter treten, im Fall von hohen Datenraten auf den Leiterbahnen, kapazitiv und induktiv bedingte Störeinkopplungen in den Leiterbahnen und damit ein Einfluß auf die Nutzdaten auf. Ebenfalls kann es bei hohen Datenraten zu einer unerwünschten Abstrahlung von Signalen von diesen Leiterbahnen kommen, die wiederum Störungen verursachen.
Diese Faktoren machen bei der herkömmlichen Technologie das Einführen von Schirmleitungen und Schirmflächen zwischen den Datenleitungen und den verschiedenen Ebenen des Multilayers nötig, dadurch wird die mögliche nutzbare Fläche des Multilayers verkleinert.

Zu einem weiteren Problem kommt es durch Dämpfung der Datensignale auf den Leiterbahnen.
Bei längeren Leitungen treten zusätzlich Laufzeitverschiebungen zwischen den Datensignalen auf.

So muß bereits im Vorfeld auf eine günstige Lage der einzelnen Komponenten zueinander geachtet werden, was die Planungsfreiheit einschränkt.

Auch größere Einheiten, wie beispielsweise Schaltschränke oder Basisstationsschaltschränke (Shelter), beinhalten eine Vielzahl von hochintegrierten Schaltungen mit elektrischen Komponenten und Baugruppen, die über Kabelbäume oder über komplexe Leitungsvorrichtungen (Backplanes) miteinander verbunden sind. Diese Anordnungen sind ebenfalls mit den oben aufgeführten Problemen behaftet.

Der vorliegenden Erfindung liegt deshalb die Aufgabe zugrunde, eine hochintegrierten elektrische Schaltung und ein Verfahren zu entwickeln, bei denen ein Datenaustausch zwischen elektrischen Komponenten und Baugruppen der Schaltung weitgehend unabhängig vom verwendeten Träger der Komponenten und dessen Leitungen stattfindet.

Die Aufgabe wird durch eine Schaltung mit den Merkmalen des ersten Anspruches gelöst.
Die Aufgabe der Entwicklung des oben beschriebenen Verfahrens wird durch die Merkmale des ersten Verfahrensanspruches gelöst.
Vorteilhafte Weiterbildungen der Erfindung sind in den Unteransprüchen angegeben.

Die Erfindung beinhaltet eine elektrische Schaltung mit nichtleitungsgebundenem Datenaustausch mittels Funkkommunikation und ein Verfahren zum nichtleitungsgebundenen Datenaustausch mittels Funkkommunikation bei dieser Schaltung, bei denen mindestens zwei elektrische Komponenten mit nichtleitungsgebundener Funkschnittstelle beinhaltet sind.

Diese Schaltung ist Teil eines Systems, das von seiner Umwelt und unerwünschten Einflüssen vorzugsweise durch eine elektrische bzw. magnetische Abschirmung abgetrennt ist. Es handelt sich daher um ein abgeschlossenes, elektrisch und/oder magnetisch abgeschirmtes System.

Beispielsweise könnte es sich bei diesem abgeschirmten System um eine abgeschirmte Leiterplatte oder einen Schaltschrank oder einen Basisstationsschaltschrank (Shelter) oder um ein Fahrzeug bzw. Flugzeug handeln.

Die Komponenten weisen je eine nichtleitungsgebundene Funkschnittstelle auf, über die eine Datenübertragung realisiert wird. Diese Datenübertragung kann ausschließlich oder teilweise über die Funkschnittstelle erfolgen. Die Komponenten tauschen mittels eines Vielfachzugriffsverfahrens Daten gleichzeitig aus. Die Funkkommunikation findet dabei vorzugsweise im Frequenzbereich von 0,3 GHz bis 4 GHz statt.

Die nichtleitungsgebundene Funkschnittstelle enthält mindestens eine Sende und eine Empfangseinrichtung, über die die Funkkommunikation zwischen den Komponenten abgewickelt wird. Die Komponente umfasst ein Interface, über das eine Datenübertragung zwischen einer eigentlichen Funktionseinheit der Komponente und der Funkschnittstelle der Komponente abgewickelt wird. Diese Datenübertragung über das Interface wird vorzugsweise mit Hilfe eines in ihm enthaltenen WCDMA oder Bluetooth oder UTRA Interface durchgeführt.

Die Funkkommunikation zwischen den Komponenten wird vorzugsweise mit einem WCDMA oder einem Bluetooth oder einem UTRA Verfahren durchgeführt. Bei diesen Verfahren wird mittels eines orthogonalen Spreizcodes oder eines quasi-orthogonalen Spreizcodes oder einer Pseudo-Noise-Folge als Spreizcode das Nutzsignal gespreizt. Jeder Komponente wird ein fester Spreizcode zugewiesen, der als Adresse dieser Komponente verwendet wird. Dieser Adresscode ist in jeder Komponente in einer Einrichtung abgespeichert. Jede Komponente gewinnt im Empfangsfall mit Bandspreiztechnik und dem ihr zugewiesenen Adresscode als Spreizcode durch Faltung das Nutzsignal bzw. verschlüsselt im Sendefall mit Bandspreiztechnik und dem Adresscode der Empfängerkomponente als Spreizcode das Nutzsignal.

Die Komponenten werden über externe Anschlüsse vorzugsweise nur mit Energie und/oder mit externem Takt versorgt und beinhalten nur die jeweils benötigten Anschlüsse.
Die Komponenten können ebenfalls eine eigene, in sie eingebrachte Energieversorgung, beispielsweise eine Batterie, beinhalten. Dann können an der Komponente die externen Anschlüsse zur Energieversorgung entfallen.

Der externe Takt und damit die externe Taktversorgung der Komponente bzw. deren externer Taktanschluß kann bei der Verwendung von Pseudo-Noise-Folgen als Spreizcode entfallen. Die im Sende- und Empfangsfall beteiligten Komponenten synchronisieren sich dann über ihre Funkschnittstelle, unabhängig von anderen Komponenten.

Eine Komponente kann dabei nicht nur als einzelner elektrischer Baustein sondern auch als Baugruppe oder als Schaltung ausgeführt sein.

Die Komponenten sind auf mindestens einem Träger fixiert. Dieser Träger versorgt sie vorteilhafterweise nur mit Energie und/oder mit externen Taktsignalen.

Um mögliche unerwünschte Störungen zwischen den einzelnen Komponenten intern zueinander, aber auch nach außen hin als Gesamtschaltung auszuschließen, ist es vorteilhaft, noch Maßnahmen zur elektrischen und/oder magnetischen Abschirmung zu treffen.
Dabei werden die Komponenten im Bedarfsfall intern zueinander aber auch als Gesamtschaltung nach außen hin mit einem elektrisch und/oder magnetisch abschirmenden Material ausgestattet. Das abschirmende Material kann dabei beispielsweise aus einer Metallplatte, einer metallischen Schicht oder aus einer elektrisch abschirmenden Schaum-Dämmschicht oder aus einer Kombination daraus bestehen.
Die Abschirmung könnte als abgeschirmte Leiterplatte, als Gehäuse, als Schaltschrank, als Basisstationsschaltschrank, als Fahrzeugchassis oder als Flugzeughülle ausgeführt sein.

Die Abschirmung mittels der Schaum-Dämmschicht kann dabei auf einem Prinzip der Oberflächenstreuung an den Poren eines leitfähigen Schaumes beruhen. Die Abschirmung wird auf ein gleiches Ausgleichspotential gelegt.

Durch die Verwendung von Vielfachzugriffsverfahren können alle Komponenten gleichzeitig miteinander kommunizieren und Daten austauschen. Eine einfache Reduzierung von Störungen in der Komponente im Empfangsfall wird durch die Verwendung von Bandspreizverfahren ermöglicht. Gleichzeitig können gegenseitige Störungen durch Interferenz und Laufzeitunterschiede reduziert werden.

Durch die Verwendung einer nichtleitungsgebundenen Funkkommunikation erfolgt die Datenübertragung mit Lichtgeschwindigkeit. Sie unterliegt damit nicht mehr den Beschränkungen von Leitungen und Leiterbahnen bzw. von Trägern und deren Eigenschaften.
Bisher verwendete Kabelbäume und komplexe Leitungsvorrichtungen (Backplanes) in größeren Anordnungen wie in Basisstationsschaltschränken können zum großen Teil entfallen oder werden stark vereinfacht .

Durch die Verwendung von nur einer Frequenz bei der Funkkommunikation und durch fest zugewiesene Adresscodes zu den einzelnen Komponenten, entfallen in den Komponenten aufwendig zu realisierende Filter.

Durch die beschriebenen Zugriffsverfahren ist es möglich, auf kostengünstige Standardbausteine zurückzugreifen.

Durch die hohe nutzbare Bandbreite kann eine ausreichend hohe Datenübertragungsrate gewährleistet werden.

Die Packungsdichte der Komponenten kann durch die von den Datenleitungen freiwerdende Fläche innerhalb einer integrierten Schaltung stark erhöht werden. Auch auf die relative Lage der Komponenten zueinander muß keine Rücksicht mehr genommen werden.

Da es sich hier um ein räumlich abgeschlossenes, vorzugsweise elektrisch und/oder magnetisch abgeschirmtes System handelt, kann auf hohe Leistungen verzichtet werden.

Bluetooth-Verfahren arbeiten zur Zeit mit Leistungen von weniger als 1mW. Bei Verwendung von UTRA-Technologien bewegt sich diese Leistung sogar im Bereich von 0,04 µW. Im Rahmen dieser Erfindung können somit vorteilhafterweise Reichweiten zwischen ca. 10 cm und 10 m mit sehr geringer Leistung erreicht werden. Damit sind Anwendungen dieser Erfindung nicht nur in den hochintegrierten elektrischen Schaltungen selbst, sondern auch in der räumlichen näheren Umgebung zwischen mehreren Schaltungen und deren Komponenten und Baugruppen möglich.

Wird eine Platine als Träger ausgestaltet, so ist ein weiterer Vorteil das sehr einfache Platinenkonzept, das sich hier ergibt. Die Platine kann gegebenenfalls mit einer integrierten elektrischen und/oder magnetischen Abschirmung ausgestattet werden.

Eine Vergrößerung der elektrischen Gesamtschaltung, bestehend aus einzelnen Komponenten und Baugruppen, ist später ebenfalls relativ einfach zu realisieren.

Anwendungsbeispiele der Erfindung finden sich bei allen hochkomplexen, hochintegrierten elektrischen Schaltungen in abgeschirmten Gehäusen, wie z.B. in Computern, Steuerungen und bei Telekommunikationsgeräten.
Anwendungen dieser Erfindung sind auch in Schaltschränken, in Basistationsschaltschränken (Shelter), in Fahrzeugen und in Flugzeugen möglich.

Im folgenden wird ein Ausführungsbeispiel der Erfindung anhand einer Zeichnung näher erläutert. Dabei zeigt
- FIG 1: den Aufbau einer einzelnen Komponente und ihre Umgebung gemäß der Erfindung.
- FIG 2: eine Abschirmung zwischen zwei Komponenten gemäß der Erfindung.
- FIG 3: ein Basisstationsschaltschrank (Shelter) mit nichtleitungsgebundenen Baugruppen gemäß der Erfindung und leitungsgebundenen Baugruppen.

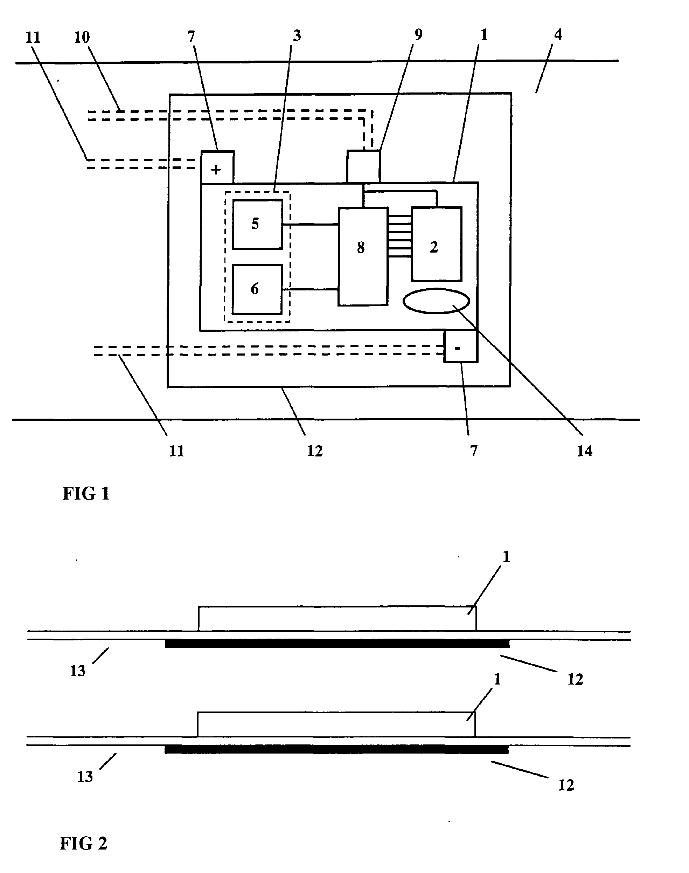

Die FIG 1 zeigt den Aufbau einer zum Datenaustausch verwendeten Komponente 1 und ihre Umgebung. Die Komponente 1 beinhaltet mindestens eine eigentliche Funktionseinheit 2 der elektrischen Komponente 1, eine Sendeeinrichtung 5, eine Empfangseinrichtung 6, eine Funkschnittstelle 3, ein Interface 8, externe Anschlüsse 7 zur Energieversorgung der Komponente 1, einen externen Anschluß 9 zur Taktversorgung der Komponente 1, der optional ausgeführt sein kann, eine Energieversorgung 14 innerhalb der Komponente 1, die optional ausgeführt sein kann, einen Träger 4, eine Einrichtung 10 zur externen Taktversorgung, eine Einrichtung 11 zur externen Energieversorgung und eine elektrische und/oder magnetische Abschirmung 12.

In einer hochintegrierten elektrischen Schaltung in einem abgeschlossenen, elektrisch abgeschirmten System befinden sich mindestens zwei Komponenten 1. Jede Komponente 1 verfügt über mindestens eine nichtleitungsgebundene Funkschnittstelle 3. Diese Funkschnittstelle 3 besteht aus mindestens einer Sendeeinrichtung 5 und einer Empfangseinrichtung 6. Die Komponenten 1 stehen durch Funkkommunikation miteinander in Verbindung. Die Funkkommunikation zwischen den Komponenten 1 findet über die Funkschnittstelle 3 statt. Die Funkkommunikation wird dabei mittels eines Vielfachzugriffsverfahren abgewickelt, das den gleichzeitigen Zugriff der Komponenten 1 auf die Daten erlaubt. Dadurch wird ermöglicht, daß alle Komponenten 1 gleichzeitig untereinander Daten per Funkkommunikation austauschen können.

Die Kommunikation der Komponenten 1 kann ausschließlich oder zumindest teilweise über die Funkschnittstelle 3 erfolgen.

Die Funkkommunikation findet dabei typischerweise im Bereich von 0,3 Gigahertz bis 4 Gigahertz statt und liegt damit im Bereich der klassischen Funkkommunikation.

Jede Komponente 1 weist externe Anschlüsse 7 zur Energieversorgung der Komponente 1 auf. Weiterhin weist jede Komponente 1 einen externen Anschluß 9 zur Taktversorgung der Komponente 1 auf. Der externe Anschluß 9 zur Taktversorgung der Komponente 1 kann je nach dem verwendeten Vielfachzugriffsverfahren optional ausgeführt sein.
Bei Verwendung einer optionalen Energieversorgung 14 innerhalb der Komponente 1 können die externen Anschlüsse 7 zur Energieversorgung entfallen.

Als Vielfachzugriffsverfahren werden WCDMA oder Bluetooth oder UTRA Verfahren angewendet. Bei diesen Verfahren werden die zu übertragenden Daten mittels Codes gespreizt. Diese Codes bestehen aus orthogonalen, bzw. quasiorthogonalen Codes (z.B. beruhend auf WALSH-Funktionen) oder aus sogenannten Pseudo-Noise-Folgen. Werden Pseudo-Noise-Folgen als Spreizcode verwendet, so kann die externe Taktversorgung 10 über die externen Anschlüsse 9 zur Taktversorgung der an der Funkkommunikation beteiligten Komponenten 1 entfallen. Dies bedeutet dann einen geringeren Zeit- und Arbeitsaufwand. Auch das Datenprotokoll vereinfacht sich durch das Entfallen der externen Taktversorgung 10. Die beteiligten Komponenten 1 im jeweiligen Sende- bzw. Empfangsfall synchronisieren sich dann über die Funkschnittstelle 3, unabhängig von den anderen Komponenten 1.

Eine eigentliche elektrische Funktionseinheit 2 der Komponente 1 stellt zum Beispiel für den Sendefall ihre Daten einem Interface 8 zur Verfügung. Dieses Interface 8 ist zwischen der eigentlichen elektrischen Funktionseinheit 2 der Komponente 1 und der Funkschnittstelle 3 angeordnet. Über dieses Interface 8 wird die Datenübertragung zwischen der eigentlichen elektrischen Funktionseinheit 2 der Komponente 1 und der Funkschnittstelle 3 abgewickelt.
Das Interface 8 beinhaltet, je nach verwendetem Vielfachzugriffsverfahren, mindestens ein WCDMA oder ein Bluetooth oder ein UTRA-Interface. Man ordnet nun jeder Komponente 1 einen festen Spreizcode als Adress-Code zu. Verwendet man nun im Sendefall den Adress-Code der Komponente 1, die empfangen soll, zugleich als Spreizcode bei der sendenden Komponente 1, so kann dieser Spreizcode auch zur Adressierung der Komponente 1, die empfangen soll, verwendet werden. Im Sendefall wird über das Interface 8 und der Sendeeinrichtung 5 mittels Bandspreiztechnik und dem zugeordnetem Adresscode der empfangenden Komponente 1 das zu sendende Nutzsignal verschlüsselt und abgestrahlt. Die Komponente 1 bekommt im Empfangsfall die verschlüsselten Daten über die Funkschnittstelle 3 und bildet mit Hilfe des Interface 8 dann wieder mittels Bandspreiztechnik und dem ihr zugeordneten Adresscode durch Faltung das Nutzsignal. Die so gewonnenen Daten werden dann über das Interface 8 wieder der eigentlichen Funktionseinheit 2 der Komponente 1 zur Verfügung gestellt.

Die Komponenten 1 sind auf mindestens einem Träger 4 fixiert. Die Träger 4 weisen eine Einrichtung 11 zur externen Energieversorgung der Komponenten 1 auf. Weiterhin können diese Träger 4 beispielsweise eine Einrichtung 10 zur externen Taktversorgung der Komponenten 1 aufweisen. Diese externe Taktversorgung könnte ebenfalls über die Funkschnittstelle der Komponenten 1 erfolgen, jedoch vereinfacht sich das Protokoll der Datenübertragung, wenn diese externe Taktversorgung für jede Komponente 1 durch den externen Anschluß 9 zur Taktversorgung erfolgt. Beinhalten die Komponenten 1 eine interne Energieversorgung 14, die optional sein kann, so kann auf diesem Träger 4 die Einrichtung 11 zur Energieversorgung der Komponenten 1 entfallen.

Um mögliche unerwünschte Störungen zwischen den einzelnen Komponenten 1 bzw. auch nach außen hin als Gesamtschaltung auszuschalten, werden noch elektrische und/oder magnetische Abschirmmaßnahmen getroffen. Dabei können, je nach Anwendungsfall, die Träger 4 und/oder die Komponenten 1 intern zueinander mit einer elektrischen und/oder magnetischen Abschirmung 12 ausgestattet werden, hier rechteckig ausgeführt. Diese Abschirmung 12 kann beispielsweise als Metallplatte und/oder als metallische Schicht und/oder als elektrisch abschirmende Schaumdämmschicht oder als eine Kombination daraus ausgeführt sein. Die Schaumdämmschicht kann auf einem Prinzip der Oberflächenstreuung an den Poren eines leitfähigen Schaumes basieren. Die Abschirmung 12 wird auf ein gleiches Ausgleichspotential gelegt.

Die FIG 2 zeigt zwei elektrische Komponenten 1, zwei Leiterplatten 13 und zwei Abschirmungen 12.
Im konkreten Anwendungsfall sind zwei elektrische Komponenten 1 auf je einer einseitig bestückten Leiterplatte 13 fixiert. Hier wird die elektrische und/oder magnetische Abschirmung 12 zum Beispiel auf der Rückseite der einseitig bestückten Leiterplatten 13 aufgebracht. Die Abschirmung 12 ist vorteilhafterweise als Metallschicht ausgeführt und kann auch zur Wärmeableitung benutzt werden.
Zur weiteren Minimierung von unerwünschten Reflektionen zwischen den einseitig bestückten und tragenden Leiterplatten 13, bzw. zwischen den Komponenten 1 und den einseitig bestückten Leiterplatten 13 kann ebenfalls zusätzlich oder ausschließlich die vorher erwähnte Schaumdämmschicht verwendet werden.

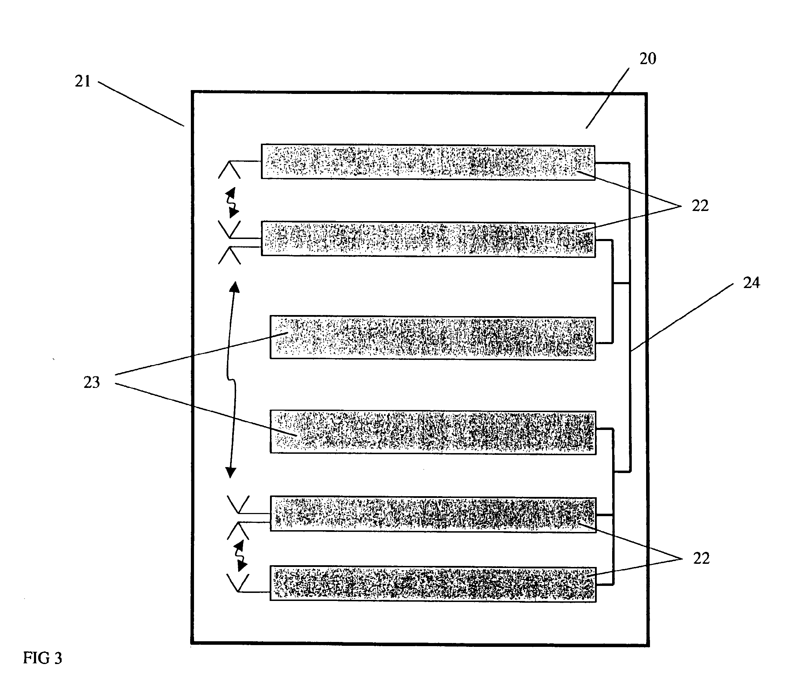

Die FIG 3 zeigt einen Basisstationsschaltschrank 20, sein elektrisch und/oder magnetisch abschirmendes Gehäuse 21, vier elektrische Baugruppen 22 mit Funkkommunikationseinrichtung, zwei Baugruppen mit leitungsgebundener Kommunikationseinrichtung und eine Leitungsvorrichtung 24 (Backplane).
Ein Basistationsschaltschrank 20 wird von einem elektrisch und/oder magnetisch abschirmenden Gehäuse 21 umgeben. Dadurch wird ein abgeschlossenens System erzeugt. Der Basisstationsschaltschrank 20 setzt sich aus beispielsweise vier Baugruppen 22 zusammen, die untereinander mittels nichtleitungsgebundener Funkkommunikation Daten austauschen. Er beinhaltet weiterhin zwei Baugruppen 23, die über die Leitungsvorrichtung 24 untereinander leitungsgebunden Daten austauschen. Sowohl die Baugruppen 22 als auch die Baugruppen 23 sind über die Leitungsvorrichtung 24 miteinander verbunden und können somit Daten untereinander austauschen.

Die Baugruppen können beispielsweise Combiner, Carrier Units, Line Cards, Verstärkerbaugruppen, Core-Baugruppen und Energieversorgungen beinhalten.

## Patentansprüche

1. Hochintegrierte elektrische Schaltung, die in einem abgeschlossenen, elektrisch und/oder magnetisch abgeschirmten System beinhaltet ist und mindestens zwei elektrische Komponenten umfasst,
bei der die Komponenten mindestens eine nichtleitungsgebundene Funkschnittstelle aufweisen,
bei der die Komponenten mindestens eine Einrichtung zum gleichzeitigen Datenaustausch untereinander enthalten, die nach einem Vielfachzugriffsverfahren arbeitet.

2. Schaltung nach Anspruch 1, bei der die Komponenten eine Einrichtung für Funkübertragungen im Bereich von 0,3 GHz bis 4 GHz aufweisen.

3. Schaltung nach Anspruch 1, bei der die Funkschnittstelle mindestens eine Sende- und eine Empfangseinrichtung enthält.

4. Schaltung nach Anspruch 1, bei der die Komponenten mindestens eine eigentliche elektrische Funktionseinheit der Komponente und/oder einen Energieversorgungseingang und/oder einen Takteingang und/oder eine interne Energieversorgung enthalten.

5. Schaltung nach Anspruch 1 oder 4, bei der die Komponenten mindestens ein Interface zwischen der eigentlichen elektrischen Funktionseinheit der Komponente und der Funkschnittstelle aufweisen, das die Datenübertragung zwischen ihnen übernimmt.

6. Schaltung nach Anspruch 5, bei der das Interface mindestens ein WCDMA oder ein Bluetooth oder ein UTRA Interface enthält.

7. Schaltung nach Anspruch 1, bei der die Komponenten eine Einrichtung zur Speicherung ihrer Adressen enthalten, in der der jeder Komponente zugewiesene Adresscode abgelegt ist.

8. Schaltung nach Anspruch 1, bei der jede Komponente eine Einrichtung aufweist, die mittels Bandspreiztechnik und ihrem zugewiesenen Adresscode das Nutzsignal im Empfangsfall gewinnt, bzw. die mittels Bandspreiztechnik und dem Adresscode der Empfängerkomponente das Nutzsignal im Sendefall verschlüsselt.

9. Schaltung nach Anspruch 1, bei der mindestens eine Komponente als ein Baustein oder als eine Baugruppe oder als eine Schaltung ausgeführt ist.

10. Schaltung nach Anspruch 1, bei der die Komponenten auf Träger fixiert sind, die eine Einrichtung zur Energieversorgung der Komponenten aufweisen und/oder eine Einrichtung zur externen Taktversorgung der Komponenten aufweisen.

11. Schaltung nach Anspruch 1, bei der die Komponenten als externe Anschlüsse nur die Anschlüsse zur Energieversorgung aufweisen und/oder nur die Anschlüsse zur externen Taktversorgung aufweisen.

12. Schaltung nach Anspruch 1, bei der die Komponenten intern zueinander mit einem elektrisch und/oder magnetisch abschirmenden Material ausgestattet sind.

13. Schaltung nach Anspruch 1 oder 12, bei der die Komponenten nach außen hin als Gesamtschaltung mit einem elektrisch und/oder magnetisch abschirmenden Material ausgestattet sind.

14. Schaltung nach Anspruch 12 oder 13, bei der das abschirmende Material eine Metallplatte und/oder eine metallische Schicht und/oder einer auf dem Prinzip der Oberflächenstreuung an den Poren eines leitfähigen Schaumes basierenden Dämmschicht ist.

15. Schaltung nach Anspruch 12 bis 14, bei der das abschirmende Material auf einem gleichen Ausgleichspotential liegt.

16. Schaltung nach Anspruch 12 bis 15, deren elektrische/magnetische Abschirmung eine Leiterplatte und/oder einen Schaltschrank und/oder einen Basisstationsschaltschrank und/oder ein Fahrzeuggehäuse und/oder ein Flugzeuggehäuse umfasst.

17. Verfahren zum Datenaustausch mittels nichtleitungsgebundener Funkkommunikation in einem abgeschlossenen, elektrisch und/oder magnetisch abgeschirmten System zwischen mindestens zwei elektrischen Komponenten einer hochintegrierten elektrischen Schaltung,
bei der die Komponenten über mindestens eine nichtleitungsgebundene Funkschnittstelle miteinander kommunizieren,
bei der die Komponenten gleichzeitig untereinander mit Hilfe eines Vielfachzugriffsverfahrens Daten austauschen.

18. Verfahren nach Anspruch 17, bei dem die Komponenten ihre Funkkommunikation im Bereich von 0,3 GHz bis 4 GHz abwickeln.

19. Verfahren nach Anspruch 17, bei dem über eine Sendebzw. über eine Empfangseinrichtung der Funkschnittstelle die Funkkommunikation zwischen den Komponenten abwickelt wird.

20. Verfahren nach Anspruch 17, bei dem über ein Interface die Datenübertragung zwischen der eigentlichen elektrischen Funktionseinheit der Komponente und der Funkschnittstelle abgewickelt wird.

21. Verfahren nach Anspruch 20, bei dem die Datenübertragung über das Interface mit Hilfe von mindestens einem in ihm enthaltenen WCDMA oder Bluetooth oder UTRA Interface durchführt wird.

22. Verfahren nach Anspruch 17, bei dem die Funkkommunikation zwischen den Komponenten mit einem WCDMA oder einem Bluetooth oder einem UTRA Verfahren durchgeführt wird.

23. Verfahren nach Anspruch 17, bei dem jeder Komponente ein fester Code zugewiesen wird, der als Adresse dieser Komponente verwendet wird.

24. Verfahren nach Anspruch 17 oder 23, bei dem jede Komponente im Empfangsfall mit Bandspreiztechnik und dem ihr zugewiesenen Adresscode durch Faltung das Nutzsignal gewinnt, bzw. das Nutzsignal im Sendefall mit Bandspreiztechnik und dem Adresscode der Empfängerkomponente verschlüsselt.

25. Verfahren nach Anspruch 17, bei dem die Komponenten über externe Anschlüsse nur mit Energie und/oder mit externem Takt versorgt wird.

26. Verfahren nach Anspruch 17 oder 25, bei dem mindestens eine Komponenten über eine interne Energieversorgung mit Energie versorgt werden.

27. Verfahren nach Anspruch 17, bei dem die Komponenten auf Träger fixiert werden.

28. Verfahren nach Anspruch 28, bei dem der Träger mit Energie und/oder mit Takt versorgt wird.

29. Verfahren nach Anspruch 17, bei dem die Komponenten intern zueinander mit einem elektrisch und/oder magnetisch abschirmenden Material ausgestattet werden.

30. Verfahren nach Anspruch 17 oder 29, bei dem die Komponenten nach außen hin als Gesamtschaltung mit einem elektrisch und/oder magnetisch abschirmenden Material ausgestattet werden.

31. Verfahren nach Anspruch 29 oder 30, bei dem als abschirmendes Material eine Metallplatte und/oder eine metallische Schicht und/oder eine elektrisch abschirmende Schaum-Dämmschicht verwendet wird.

32. Verfahren nach Anspruch 31, bei dem die elektrische Abschirmung der Schaum-Dämmschicht auf dem Prinzip der Oberflächenstreuung an den Poren des leitfähigen Schaumes beruht.

33. Verfahren nach Anspruch 29 bis 32, bei dem das abschirmende Material auf ein gleiches Ausgleichspotential gelegt wird.

34. Verfahren nach Anspruch 17, bei dem mindestens eine Komponente als ein Baustein oder als eine Baugruppe oder als eine Schaltung ausgeführt wird.

35. Verfahren nach Anspruch 34, bei dem Bausteine, Baugruppen und Schaltungen miteinander kommunizieren.
